# EUROPÄISCHE PATENTSCHRIFT

(11) **EP 2 277 212 B1**
(45) Veröffentlichungstag und Bekanntmachung des Hinweises auf die Patenterteilung: **10.08.2016**
(21) Anmeldenummer: 08784192.0
(22) Anmeldetag: 13.06.2008
(51) Int. Cl.: H01L 51/52, H05B 33/08

(54) **LICHTEMITTIERENDES ORGANISCHES BAUELEMENT MIT SICHERUNGSSTRUKTUR**
LIGHT EMITTING ORGANIC COMPONENT WITH FUSE STRUCTURE
COMPOSANT ORGANIQUE ÉMETTEUR DE LUMIÈRE DOTÉ D'UNE STRUCTURE DE PROTECTION

(30) Priorität: 15.04.2008 DE 102008019048
(43) Veröffentlichungstag der Anmeldung: 26.01.2011
(73) Patentinhaber: Novaled GmbH, 01307 Dresden (DE)
(72) Erfinder: LANGGUTH, Oliver, 01129 Dresden (DE); RENTENBERGER, Stephan, 01277 Dresden (DE); ZIMMERMANN, Sven, 01324 Dresden (DE); WELLMANN, Philipp, 64285 Darmstadt (DE)
(74) Vertreter: Bittner, Thomas L.
(86) Internationale Anmeldenummer: PCT/DE2008/000956
(87) Internationale Veröffentlichungsnummer: WO 2009/127174

(56) Entgegenhaltungen:
- EP-A- 1 003 229
- EP-A- 1 549 110
- WO-A-2008/099315
- US-A1- 2003 010 985

## Beschreibung

Die Erfindung bezieht sich auf ein lichtemittierendes organisches Bauelement, ein Verfahren zum Herstellen und eine Anordnung mit mehreren lichtemittierenden organischen Bauelementen sowie eine Elektrodenstruktur.

### Hintergrund der Erfindung

Organische Leuchtdioden (OLEDs) haben in den vergangenen Jahren zunehmend an Bedeutung gewonnen. So sind neben Anwendungen im Anzeigenbereich auch vermehrt Anwendungen für Beleuchtungszwecke in den Fokus der Entwicklungsarbeiten gerückt. Das große Potential der Technologie in diesem Feld wird allgemein anerkannt und es wird davon ausgegangen, dass OLEDs zukünftig eine der wichtigsten Technologien im Lampenbereich werden. Mittlerweile sind sowohl die Leistungseffizienzen als auch die Bauteillebensdauern auf einem konkurrenzfähigen Niveau zu alternativen Beleuchtungstechnologien wie Glühbirnen, Leuchtstoffröhren oder anorganische LEDs angelangt.

Trotzdem sind manche technischen Hürden bisher noch nicht überwunden, welche einem kommerziellen Durchbruch am Markt bisher im Wege stehen. Eine dieser Hürden ist es, die Gesamtlichtmenge, welche ein Bauteil emittieren kann, zu erhöhen. Diese Lichtmenge wird im wesendlichen durch zwei Faktoren bestimmt, zum einen die Fläche der OLED und zum anderen deren Helligkeit. Letztere kann nicht beliebig gesteigert werden, da mit ansteigender Helligkeit eine exponentielle Abnahme der Lebensdauer einhergeht. Darüber hinaus wird ab einer bestimmten Helligkeit das zwischen den Elektroden der OLED anliegende Feld so groß, dass es zu einem Durchbruch und somit einer Kurzschlussbildung kommt. Zum heutigen Zeitpunkt geht man davon aus, dass die Anwendungshelligkeiten im Bereich von 500 bis 10,000 cd/m² liegen werden.

Somit bleibt zur Steigerung der Lichtmenge in erster Linie die Vergrößerung der aktiven Leuchtfläche. Für zukünftige OLED-Anwendungen im Beleuchtungssektor werden sich die aktiven Flächen daher vermutlich in einer Spanne von wenigen Quadratzentimetern bis hin zu einem Quadratmeter und mehr bewegen. Da OLEDs typischerweise bei einer Spannung von etwa 2 - 10 V betrieben werden und da diese Spannung von der Fläche unabhängig ist, steigert sich bei ansteigender Gesamtfläche der fließende Strom. So würde beispielsweise bei einer Stromeffizienz des Bauteils von 50 cd/A und einer Betriebshelligkeit von 5,000 cd/m² bereits bei einer vergleichsweise geringen Fläche von 100 cm² ein Strom von 1 Ampere fließen.

Bereits die Zuleitung eines solch hohen Stromes würde in den meisten praktischen Anwendungen bereits für kaum lösbare Probleme sorgen. Eine weitere Vergrößerung der Fläche würde diese Probleme weiter verschärfen.

Als Lösung dieses Problems wurde bereits vorgeschlagen, eine Vielzahl von kleinen OLED-Elementen mit vergleichsweise kleiner Fläche in Reihe zu schalten (GB 2392023 A). Hierdurch wird die Betriebsspannung des Bauteils um einen Faktor erhöht, welcher in etwa der Anzahl der in Reihe geschalteten OLED-Elemente entspricht. Gleichzeitig verringert sich der Betriebsstrom ebenfalls etwa um diesen Faktor. Somit kann die gesamte Lichtmenge und die Leistungseffizienz gleich gehalten werden, die elektrische Ansteuerung des Bauteils vereinfacht sich jedoch deutlich, da es gewöhnlicherweise wesentlich einfacher ist eine hohe Betriebsspannung zu zuführen.

Eine vorteilhafte Eigenschaft dieser Reihenschaltung von OLED-Elementen innerhalb eines Bauteiles ist es, dass im Falle der Bildung eines Kurzschlusses zwischen Kathode und Anode eines OLED-Elementes keine Unterbrechung des Strompfades auftritt. Auch wenn in diesem Fall ein Teil des Bauteils, nämlich das OLED-Element mit dem Kurzschluss, kein Licht mehr emittiert, so bleibt doch die emittierte Gesamtlichtmenge des Bauteiles nahezu unverändert, da nun über den anderen, verbleibenden Elementen eine entsprechend höhere Spannung abfällt. Somit kann ein solches Bauteil auch nach Bildung eines Kurzschlusses noch seinen Verwendungszweck erfüllen.

Sofern ein Bauteil hingegen lediglich aus einer einzigen großen OLED besteht, so reduziert sich die Lichtleistung signifikant nach einer Kurzschlussbildung, da nun ein großer Teil des Stromes über den Kurzschluss fließt ohne in Licht umgewandelt zu werden. Falls eine konstante Versorgungsspannung an dem Bauteil anliegt, würde außerdem der fließende Strom dramatisch anwachsen, wodurch es in vielen Fällen zu einer starken Aufheizung an der Stelle des Kurzschluss kommen wird. Aus diesen Gründen können Bauteile mit einer einzigen großen OLED-Fläche nach einer Kurzschlussbildung nicht weiter verwendet werden.

Die Herstellung von OLED-Bauteilen mit einer Reihenschaltung von OLED-Elementen ist jedoch deutlich komplexer als die Herstellung einer einzelnen großen Diode.

Zunächst ist für eine solche Lösung eine Strukturierung der substratseitigen Elektrode notwendig, um die Teilelektroden der Reihenschaltung zu definieren. Weiterhin müssen auch die organischen Schichten sowie die Topelektrode strukturiert werden um die Reihenschaltung auf zu bauen. Eine solche Strukturierung ist prinzipiell mit verschiedenen Methoden möglich. Sofern die organischen Materialien der OLED mittels Vakuumverdampfung prozessiert werden, kann eine solche Strukturierung mittels Schattenmasken erfolgen. Auch die Prozessierung der Organik mittels Transfermethoden, bei denen die organischen Materialien von einem Trägerfilm mittels lokaler Aufheizung durch einen Laserstrahl auf das Substrat erfolgen, ist möglich. Diese Methode kann jedoch nur für die organischen Schichten verwendet werden, nicht hingegen für die Topelektrode, welche gewöhnlicherweise aus Metallen wie Aluminium, Silber, Kalzium oder Magnesium, bzw. aus transparenten Oxiden wie Indium-Zinn-Oxid (ITO) besteht. Um diese Materialien zu strukturieren wird ebenfalls gewöhnlicherweise auf eine Abscheidung durch Schattenmasken zurückgegriffen.

Alle diese genannten Strukturierungsmethoden erhöhen jedoch die Komplexität des Herstellungsprozesses, was diesen zwangsläufig auch verteuert. Die erreichbaren Auflösungen mit Schattenmasken sind darüber hinaus limitiert, wodurch der minimale Abstand zwischen den OLED-Elementen der Reihenschaltung begrenzt wird. Weiterhin wird die Verwendung von Schattenmasken aufwändiger wenn die Strukturen auf dem Substrat kleiner werden. Sofern Strukturen im Bereich einiger 100 µm dargestellt werden sollen ist für gewöhnlich eine Feinjustierung der Schattenmaske zum Substrat erforderlich, welche zeitintensiv und kostspielig ist und gewöhnlicherweise mit Hilfe von Mikroskopen erfolgt. Vergrößert man jedoch die abzubildenden Strukturen auf eine gewisse Dimension, wie dies zum Beispiel bei einer Größe der OLED-Elemente von etwa 1 cm² der Fall ist, so lässt sich die Ausrichtung der Schattenmaske zum Substrat mit geringerer Präzision durchführen. Hierdurch wird dann eine einfache Ausrichtung beispielsweise durch Haltestifte möglich, welche deutlich schneller und billiger als eine Feinjustierung im Mikrometerbereich ist. Die Ausrichtung der Schattenmaske zum Substrat kann durch Haltestifte auf dem Substrat oder der Substrathalterung erfolgen.

Auch die Masken selbst müssten mit einer geringeren Präzision gefertigt werden, wodurch kostengünstigere Fertigungsmethoden wie Laserschneiden anstelle von kostenintensiven Lithographieverfahren eingesetzt werden können. Durch eine Maskenausrichtung mittels Haltestiften wird auch die Taktzeit, die zur Prozessierung der Substrate benötigt wird, verringert.

Eine Verbesserung von OLED-Beleuchtungselementen auf Basis einer vereinfachten Prozessierung größerer OLED-Elemente mit einer gemeinsamen organischen Schichtstruktur auf streifenförmig strukturierten Grundkontakten wurde bereits vorgeschlagen. In einer solchen Bauteilarchitektur wird lediglich die Grundelektrode feinstrukturiert, was mittels Photolithographie durchgeführt werden kann. Da eine photolithographische Strukturierung des Substrates gewöhnlicherweise sowieso erfolgen muss, entstehen hierdurch kaum höhere Prozesskosten. Der Vorteil der streifenförmigen Strukturierung der Grundelektrode ergibt sich aus der Tatsache, dass hierdurch innerhalb eines OLED-Elementes mit gemeinsamer organischer Schicht und gemeinsamer Gegenelektrode mehrere OLED-Streifen parallel geschaltet sind. Kommt es in einer solchen Struktur zur Bildung eines Kurzschlusses, so ist der Stromfluss über die Streifen der Grundelektrode durch deren elektrischen Widerstand limitiert. Somit ist im Falle eines Kurzschlusses nicht das gesamte OLED-Element funktionsunfähig, sondern lediglich ein Teilstreifen. Allerdings ist die Limitierung des Stromflusses durch die genaue Position des Kurzschlusses auf dem Streifen bestimmt. Ist die Strecke, welche der Strom über den Elektrodenstreifen bis zum Kurzschluss mit der Gegenelektrode zurücklegen muss, kurz, so ist auch der ohmsche Widerstand gering und ein großer Strom fließt durch den Kurzschluss und nicht durch die parallel geschalteten intakten Streifen des OLED-Elementes. Hierdurch kann es zu Effizienzverlusten des Bauteiles kommen, nachdem sich ein Kurzschluss gebildet hat. Deswegen wäre es wünschenswert, einen durch einen Kurzschluss beschädigten Streifen elektrisch von den anderen Streifen zu isolieren.

Für OLED Anzeigen ist eine elektrische Isolierung einzelner Pixel von den Ansteuerungszuleitungen bereits diskutiert worden (*M. Kimura, Y. Kubo, Analysis, "Detection and Repair of Pixel Shorts in PM-OLEDs*"*, IDW*/*AD Proceedings 2005*, *Seite 605*). In diesem Artikel schlagen die Autoren vor, bei einem Pixel mit einem Kurzschluss die Zuleitungselektrode aus Metal oder einem leitfähigen Oxid mittels eines Laserstrahles oder eines hohen Strompulses durchzubrennen. Jedoch erfordert sowohl das Abtrennen mittels eines Lasers als auch das Durchbrennen der Zuleitung durch einen Strompuls einen gewissen aktiven Aufwand. Sofern die Zuleitung mittels eines Strompulses durchtrennt werden soll ist es darüber hinaus notwendig, dass der abzutrennende OLED-Bereich individuell angesteuert werden kann. Darüber hinaus müssen die elektrischen Zuleitungen einen solch hohen Stromfluss ermöglichen, ohne selbst Schaden zu nehmen. In jedem Fall muss die Ansteuerung mittels eines Stromimpulses aktiv erfolgen, beispielsweise mittels einer geeigneten Autoanalyse- und Steuerelektronik, und erfolgt somit nicht direkt und unmittelbar durch die Kurzschlussbildung im OLED-Element selbst.

Im Falle von OLED-Beleuchtungselementen ist es in der Regel nicht möglich, mittels eines Stromimpulses einen bestimmten Bereich elektrisch zu isolieren.

Auch die Verwendung eines Lasers zum Abtrennen ist hochkomplex. Insbesondere für Bauteile, die bereits vom Nutzer eingesetzt werden, würde diese Methode das Einschicken zur Reparatur erfordern, wodurch hohe Kosten verursacht würden.

Das Dokument EP 1 003 229 A1 offenbart ein organisches Licht emittierendes Bauelement mit einer strombegrenzenden Struktur. Die strombegrenzende Struktur ist in der Nähe einer Elektrode angeordnet, um im Falle eines Kurzschlusses einen hohen Stromfluss in dem Bauelement zu unterbinden.

Das Dokument EP 1 549 110 A1 betrifft ein organisches elektrolumineszentes Bauelement mit einer Leckverhinderungsschicht, welche einen hohen elektrischen Widerstand aufweist, wenn seine Temperatur erhöht wird.

In dem Dokument US 2003/010985 A1 A2 ist ein Licht emittierendes Bauelement mit einer strukturierten Elektrode beschrieben. Zwischen Elektrodensegmenten der strukturierten Elektrode sind elektrische Sicherungen gebildet.

### Zusammenfassung der Erfindung

Aufgabe der Erfindung ist es, Technologien für ein verbessertes Ausfallverhalten in Verbindung mit elektronischen Bauelementen, insbesondere lichtemittierenden organischen Bauelementen anzugeben. Die Technologien sollen bevorzugt sowohl bei einzelnen lichtemittierenden organischen Bauelementen als auch für Anordnungen mit mehreren lichtemittierenden organischen Bauelementen einsetzbar sein.

Diese Aufgabe wird erfindungsgemäß durch eine Elektrodenstruktur für ein elektronisches Bauelement nach dem unabhängigen Anspruch 1, ein lichtemittierendes organisches Bauelement nach dem unabhängigen Anspruch 8, ein Verfahren zum Herstellen eines lichtemittierenden organischen Bauelementes nach dem unabhängigen Anspruch 9 sowie eine Anordnung mit mehreren lichtemittierenden organischen Elementen nach dem unabhängigen Anspruch 10 gelöst. Vorteilhafte Ausgestaltungen der Erfindung sind Gegenstand von abhängigen Unteransprüchen.

In einer möglichen Ausgestaltung im Zusammenhang mit einem organischen lichtemittierenden Bauelement ist der organische Bereich zusammenhängend oder mit separierten Teilabschnitten, die jedoch mit der gleichen Elektrode ansteuerbar sind, gebildet. Er kann im Fall der zusammenhängenden Ausführung als ein in der Flächebedeckung im wesentlichen geschlossener einzelner Bereich ausgeführt sein, beispielsweise in Form einer vieleckigen, einer rechteckigen, einer dreieckigen oder einer runden Fläche.

Die elektrisch verbundenen Elektrodenabschnitte können eine Parallel- oder eine Reihenschaltung oder eine Kombination hiervon bilden. Die Elektrodenabschnitte können bevorzugt als wenigstens teilweise voneinander separierte oder getrennt gebildete Elektrodenabschnitte betrachtet werden.

Die Erfindung umfasst den Gedanken, in Verbindung mit der Elektrodenkonfiguration bei elektronischen Bauelementen, insbesondere lichtemittierenden organischen Bauelementen, eine der Elektrodenkonfiguration zugeordnete, elektrische Sicherungsstruktur vorzusehen, sei es in der Zuordnung für die separat ansteuerbare Elektrode eines einzelnen Bauelementes oder für die Mehrelektrodenstruktur bei einer Anordnung mit mehreren Bauelementen. Die Mehrelektrodenstruktur wird gebildet von den zusammen geschalteten Elektroden der einzelnen Bauelemente, die zum Betrieb der Bauelemente jeweils individuell ansteuerbar sind, bei denen also unabhängig voneinander eine jeweils gewünschte Betriebsspannung angelegt werden kann. Jede Elektrode, sei es im Einzelelement oder in der Anordnung von mehreren Bauelementen, wirkt mit einer zugeordneten Gegenelektrode zusammen.

Im Fall der Bauelementeanordnung handelt es sich bei der Sicherungsstruktur um eine elektrische Bauelementsicherungsstruktur, die im Auslösefall eine elektrische Isolierung zwischen einzelnen Bauelementen bewirkt. Dieses ist für einzelne oder mehrere der von Anordnung umfasste Bauelemente wiederum kombinierbar mit der Sicherungsstruktur innerhalb des einzelnen Bauelementes.

Im hier beabsichtigten Sinne ist das einzelne lichtemittierende organische Bauelement oder Element dadurch bestimmt, dass einem organischen Bereich, welcher beispielsweise zusammenhängend gebildet ist, genau eine selbständig ansteuerbare Elektrode, die ihrerseits durchaus mehrere zusammen geschaltete und gemeinsam ansteuerbare Teilelektroden umfassen kann, zugeordnet ist, an welche beim Betrieb ein elektrisches Potential angelegt wird, um in dem organischen Bereich Licht zu erzeugen. Die wahlweise vorgesehenen Teilelektroden liegen dann stets auf dem gleichen elektrischen Potential. Demgegenüber ist die Anordnung mit mehreren lichtemittierenden organischen Bauelementen gebildet, indem mehrere Bauelemente oder Elemente, die jeweils über einen eigenen organischen Bereich verfügen, der jeweils zusammenhängend gebildet ist und über eine zugeordnete Elektrode ansteuerbar ist. Im Fall der Ausführung der einzelnen Bauelemente als lichtemittierende organische Diode können diese auch als OLED-Elemente bezeichnet werden.

Gemeinsam ist den elektrischen Sicherungsstrukturen, dass sie bei Überschreitung eines mittels Konstruktion der Sicherungsstruktur festlegbaren Grenzstroms selbstauslösend oder selbsttätig eine elektrische Verbindung unterbrechen, so dass eine elektrische Isolierung hergestellt wird. Die elektrische Sicherungsstruktur ist hierbei so ausgelegt, dass der Isolierungseffekt beim Auftreten eines Vielfachen des üblichen Betriebsstroms für das oder die Bauelemente selbsttätig ausgelöst wird. Der Aufbau der elektrischen Sicherungsstruktur ist so zu wählen, dass einerseits der übliche Betrieb des oder der Bauelemente gewährleistet ist und andererseits beim Auftreten eines erhöhten Stroms die Selbstauslösung erfolgt. Je nach Anwendungsfall stehen dem Fachmann hierfür jedoch die üblichen Designoptionen hinsichtlich Material und Strukturgestaltung wie zum Beispiel der Leiterquerschnitt elektrischer Verbindungen zur Verfügung. Die elektrische Sicherungsstruktur kann insoweit auch als selbstauslösende oder selbstisolierende Sicherungsstruktur bezeichnet werden.

Eine bevorzugte Weiterbildung der Erfindung sieht vor, dass der eine oder die mehreren weiteren Elektrodenabschnitte außerhalb des organischen Bereiches gebildet sind. Aufgrund der Ausbildung des oder der weiteren Elektrodenabschnitte außerhalb des organischen Bereiches, was einer Anordnung des oder der mehreren weiteren Elektrodenabschnitte nicht überlappend mit dem organischen Bereich entspricht, können diese auch als äußere Elektrodenabschnitte bezeichnet werden.

Bei einer zweckmäßigen Ausgestaltung der Erfindung kann vorgesehen sein, dass die elektrische Sicherungsstruktur mit einer Sicherungsteilstruktur, die einer Teilmenge der Elektrodenabschnitte zugeordnet ist, und einer weiteren Sicherungsteilstruktur gebildet ist, die einer weiteren Teilmenge der Elektrodenabschnitte zugeordnet ist. Alternativ zu dieser Ausgestaltung kann auch eine für alle Elektrodenabschnitte gemeinsame Sicherungsstruktur vorgesehen sein. Eine vorteilhafte Ausführungsform der Erfindung sieht vor, dass die elektrische Sicherungsstruktur mit wenigstens einer Sicherungseinzelstruktur gebildet ist, die einem einzelnen Elektrodenabschnitt der Elektrodenabschnitte zugeordnet ist. Auch Kombinationen eines oder mehrerer Sicherungseinzelstrukturen einerseits und Sicherungsteilstrukturen andererseits können vorgesehen sein.

Bevorzugt sieht eine Fortbildung der Erfindung vor, dass der organische Bereich über seine flächige Ausdehnung mit einem gleichen Materialaufbau gebildet ist. Dieses kann sowohl im Fall der zusammenhängenden Ausbildung als auch für die der Elektrode zugeordneten, separaten Teilbereiche vorgesehen sein. Die gleichartige oder einheitliche Ausbildung oder Zusammensetzung des organischen Bereiches über seine flächige Ausdehnung bedeutet insbesondere, dass Licht gleicher Farbe abgegeben wird. Es sind so genannte RGB-Strukturen mit verschiedenfarbigen Einzelelementen bekannt, bei denen in Teilbereichen jeweils rotes, blaues oder grünes Licht abgegeben wird, um beispielsweise so genannte RGB-Anzeigen zu bilden, und bei denen die Teilbereiche über separat ansteuerbare Elektroden betrieben werden, so dass individuell einstellbare Betriebsspannungen angelegt werden können. Die Teilbereiche weisen in sich jeweils eine einheitliche Materialzusammensetzung auf. Bei gleicher Zusammensetzung ist über die flächige Ausdehnung eine einheitliche Zusammensetzung des oder der Materialien für das Emittersystem gegeben.

Es ist vorgesehen, dass die elektrische Sicherungsstruktur eine Schicht aus organischem Material aufweist. Die organische Schicht kann eine elektrisch dotierte Schicht sein. Die Ausführung erfolgt als p-dotierte oder n-dotierte Halbleiterschicht. Die elektrische Sicherungsstruktur kann vollständig oder teilweise mit der elektrisch dotierten Schicht gebildet sein. In einer bevorzugten Ausgestaltung ist die elektrisch dotierte Schicht in ihrer Materialzusammensetzung gleich einer der Schichten aus dem organischen Bereich gebildet, was den Vorteil hat, dass die elektrisch dotierte Schicht der Sicherungsstruktur gleichzeitig mit der in gleicher Weise ausgeführten Schicht in dem organischen Bereich bei der Herstellung geschaffen werden kann, sofern dieses in den Produktionsprozess zweckmäßig integriert werden kann. Die elektrisch dotierte Schicht ist vorzugsweise mit einer Schichtdicke zwischen etwa 10 nm und etwa 100 µm gebildet. Eine Schichtdicke von etwa 10 nm wird als eine Dicke angesehen, die mindestens benötigt wird, um mit üblichen Fertigungsanlagen sicher eine geschlossene organische Schicht zu bilden 100 µm ist eine Schichtdicke, die noch in einem angemessenen prozesstechnischen Rahmen realisiert werden kann.

Alternativ oder in Ergänzung zu der Ausbildung der elektrisch dotierte Schicht kann in einer Ausgestaltung der Sicherungsstruktur eine Schicht aus organischem Material vorgesehen sein, die nicht elektrisch dotiert ist. Hinsichtlich der Schichtdicke der nicht dotierten organischen Schicht gelten die vorangehenden Ausführungen zur dotierten organischen Schicht entsprechend.

Es ist vorgesehen, dass die elektrische Sicherungsstruktur eine Metallschicht aufweist. Die elektrische Sicherungsstruktur kann vollständig oder teilweise von der Metallschicht gebildet sein, so dass sie in einer Ausführung aus der Metallschicht besteht. Auch kann eine Ausgestaltung vorsehen, dass die elektrische Sicherungsstruktur aus der Metallschicht und der Schicht aus organischem Material besteht. In einer Ausführung kann die Metallschicht mit mindestens einer der folgenden Schichten kombiniert werden, nämlich der elektrisch dotierten organischen Schicht und der organischen Schicht, die nicht dotiert ist. Die Metallschicht kann die organische Schicht in Teilbereichen oder vollständig bedecken. Hierbei kann in einer Ausführungsform vorgesehen sein, dass die Metallschicht die Schicht aus organischem Material in Abschnitten oder vollständig bedeckt. Die organische Schicht, sei sie elektrisch dotiert oder nicht, kann in Berührungskontakt mit den zugeordneten Elektrodenabschnitten oder den weiteren Elektrodenabschnitten oder ohne Kontakt hiermit gebildet sein. In den verschiedenen Ausführungen kann die Metallschicht nur mit den zugeordneten Elektrodenabschnitten, nur mit dem einen oder den mehreren weiteren Elektrodenabschnitten oder mit beiden in elektrischem Kontakt sein.

Beispielsweise weist die organische Schicht eine Schichtdicke zwischen etwa 10 nm und etwa 50 µm auf. Die Metallschicht wird vorzugsweise mit einer Schichtdicke zwischen etwa 10 nm und etwa 10 µm gebildet.

Die Schichtdicken sind so gewählt, dass im Falle eines Kurzschlusses im Bereich der Elektrodenabschnitte und dem hiermit einhergehenden, erhöhten Stromfluss die elektrisch dotierte Schicht sich so stark erwärmt, dass sie elektrisch isolierend wird, zum Beispiel indem sie aufschmilzt. Das organische Material der elektrisch dotierten Schicht und die Substratoberfläche, auf welcher das lichtemittierende organische Bauelement gebildet ist, sind so gewählt, dass die elektrisch dotierte Schicht beim Schmelzen entnetzt. Bei der Kombination mit der Metallschicht ist diese dünn genug, um im Fall der Entnetzung aufzureißen. Außerdem ist die Metallschicht so dünn, dass im Falle eines Kurzschlusses eine ausreichend große Wärme durch den ohmschen Widerstand erzeugt wird, um ein Schmelzen der elektrisch dotierten Schicht aus organischem Material zu bewirken. Die Kombination von Metallschicht und elektrisch dotierter Schicht aus organischem Material hat den Vorteil, dass die Temperatur, bei welcher der elektrische Isolierungseffekt durch die Sicherungsstruktur ausgelöst wird, genau gewählt werden kann. Hierdurch lässt sich die elektrische Sicherungsstruktur über die Parameter Schmelztemperatur der elektrisch dotierten Schicht, Dicke der Metallschicht und Design des lichtemittierenden organischen Bauelementes und hieraus folgender Stromfluss auf individuelle Anwendungszwecke anpassen.

Das Schmelzen organischer Materialien erfolgt häufig bereits bei Temperaturen unterhalb von 200°C. Elektrische Sicherungsstrukturen auf Basis von Metallen oder anderen organischen elektrischen Leitern brennen erst bei deutlich höheren Temperaturen durch.

Dünne Filme aus organischem Material können sogar bereits unterhalb ihres Schmelzpunktes einnetzen, was beispielsweise häufig in Verbindung mit flüssigkristallinen Materialien auftritt. In einer bevorzugten Ausbildung ist die organische Schicht der Sicherungsstruktur aus einem flüssigkristallinen Material hergestellt.

Ein weiterer Vorteil der Kombination von organischer Schicht, die wahlweise elektrisch dotiert ist, und Metallschicht für die elektrische Sicherungsstruktur besteht darin, dass die Metallschicht vergleichsweise dick gewählt werden kann, da sie sich im Fall des Kurzschlusses nicht so hoch erhitzen muss wie dieses bei einer reinen metallischen Sicherungsstruktur der Fall ist. Hierdurch lassen sich die ohmschen Verluste an der Sicherungsstruktur im normalen Betrieb verringern. Es ist jedoch darauf zu achten, dass die Metallschicht dünn genug ist, um durch eine der Schichten aus organischem Material aufgebrochen zu werden.

Bei einer zweckmäßigen Ausgestaltung der Erfindung kann vorgesehen sein, dass die elektrische Sicherungsstruktur als eine Schmelzsicherungsstruktur ausgeführt ist. Beim Ansprechen der elektrischen Sicherungsstruktur aufgrund eines erhöhten Stroms kommt es zum Schmelzen, wodurch eine elektrische Isolierung eintritt.

Eine vorteilhafte Ausführungsform der Erfindung sieht vor, dass die Elektrodenabschnitte wenigstens zum Teil jeweils als einen Streifenelektrodenabschnitt gebildet sind. Die Streifenelektrodenabschnitte können in beliebiger Art und Weise angeordnet sein. Auch die Bauform der Streifenelektrodenabschnitte kann je nach Anwendungsfall beliebig gewählt werden. Eine streifenförmige Ausbildung ist sowohl mit geraden Elektrodenabschnitten als auch mit Elektrodenabschnitten möglich, die nicht gerade verlaufen, beispielsweise in Zickzackform oder als Schlangenlinie.

Bevorzugt sieht eine Fortbildung der Erfindung vor, dass die Elektrode Kammteilelektroden aufweist, bei denen die hieran gebildeten, voneinander getrennten Elektrodenabschnitte wenigstens abschnittsweise ineinandergreifend angeordnet sind. Die Kammteilelektroden, welche, die Elektrode bildend, gemeinsam ansteuerbar sind, können verschiedenen geometrischen Grundformen entsprechend gebildet sein, wobei ineinandergreifende Abschnitte gegenüberliegender Teilelektroden zweckmäßig eine komplementäre Ausgestaltung aufweisen, zum Beispiel eine umgekehrte konische Ausführung. Auch Streifenelektroden in Form von Zickzack- oder Schlangenlinien können so ineinandergreifend angeordnet sein.

Die vorangehend für das lichtemittierende organische Bauelement oder Elemente beschriebenen, vorteilhaften Ausgestaltungen können in analoger Weise im Zusammenhang mit der Anordnung mit mehreren lichtemittierenden organischen Bauelementen genutzt werden, sofern sie nicht spezifisch auf ein einzelnes Bauelement beschränkt sind.

Die mehreren lichtemittierenden organischen Bauelemente können in einer vorteilhaften Ausgestaltung auf einem gemeinsamen Substrat gebildet sein, so dass mehrere lichtemittierende organische Bauelemente auf dem gleichen Substrat hergestellt sind. Auch die Bauelementsicherungsstruktur und - soweit diese für eine oder mehrere der Bauelemente vorgesehen ist - die Sicherungsstruktur, wie sie oben für das einzelne Bauelement beschreiben wurde, können dann auf dem gleichen Substrat gebildet werden.

Die mit Hilfe der Bauelementsicherungsstruktur abgesicherten und separat ansteuerbaren Elektroden der verschiedenen Bauelemente können gemäß einer Parallelschaltung oder einer Reihenschaltung oder einer Kombination hiervon miteinander verschalten sein. Bei der Ausbildung der lichtemittierenden organischen Elemente als lichtemittierende organische Diode können auf diese Weise so genannte OLED-Elemente oder -Bauelemente miteinander verschaltet und abgesichert werden.

Die vorangehend im Zusammenhang mit einem Bauelement beschriebenen Ausgestaltungsmöglichkeiten für die Elektrode können einzeln oder in beliebiger Kombination auch in Verbindung mit der Elektrodenstruktur als solcher vorgesehen sein, wobei die Elektrodenstruktur als selbständiges Produkt oder Halbzeug hergestellt werden kann, genauso wie eine Elektrodenherstellung integriert mit der Bauelementherstellung ausgeführt werden kann, sei es bei einem organischen lichtemittierenden Bauelement oder einem anderen elektronischen Bauelement. Eine getrennte Herstellung der Elektrodenstruktur mit der Elektrode in den unterschiedlichen Ausführungen kann zum Beispiel einfach dadurch erreicht werden, dass die beschriebenen Herstellungsprozesse abgebrochen werden, nachdem die Elektrode gebildet ist, ohne mit der Ausbildung des organischen Bereiches fortzufahren. Die so erzeugte Elektrodenstruktur kann dann für beliebige elektronische Bauelemente eingesetzt werden. Hierzu gehören insbesondere organische Solarzellen. Die oben beschriebenen Vorteile, soweit sie ihren Ursprung in der Elektrodenausführung als solcher haben, ergeben sich für die Elektrodenstruktur in den verschiedenen Ausgestaltungen entsprechend.

Nachfolgend werden bevorzugte Ausgestaltungen in Verbindung mit der Elektrodenstruktur noch näher erläutert, wobei im Zusammenhang mit gleichen Merkmalen die oben gemachten Erläuterungen entsprechend gelten, weshalb diese zur Vermeidung von Wiederholungen nachfolgend weggelassen werden.

Bei einer zweckmäßigen Ausgestaltung der Erfindung kann vorgesehen sein, dass bei der Elektrodenstruktur die elektrische Sicherungsstruktur mit einer Sicherungsteilstruktur, die einer Teilmenge der Elektrodenabschnitte zugeordnet ist, und einer weiteren Sicherungsteilstruktur gebildet ist, die einer weiteren Teilmenge der Elektrodenabschnitte zugeordnet ist. Alternativ zu dieser Ausgestaltung kann auch eine für alle Elektrodenabschnitte gemeinsame Sicherungsstruktur vorgesehen sein.

Eine vorteilhafte Ausführungsform der Erfindung sieht vor, dass bei der Elektrodenstruktur die elektrische Sicherungsstruktur mit wenigstens einer Sicherungseinzelstruktur gebildet ist, die einem einzelnen Elektrodenabschnitt der Elektrodenabschnitte zugeordnet ist.

Bei einer vorteilhaften Ausgestaltung der Erfindung ist vorgesehen, dass bei der Elektrodenstruktur die elektrische Sicherungsstruktur eine Schicht aus organischem Material und eine Metallschicht aufweist.

Bei einer zweckmäßigen Ausgestaltung der Erfindung kann vorgesehen sein, dass bei der Elektrodenstruktur die elektrische Sicherungsstruktur als eine Schmelzsicherungsstruktur ausgeführt ist. Beim Ansprechen der elektrischen Sicherungsstruktur aufgrund eines erhöhten Stroms kommt es zum Schmelzen, wodurch eine elektrische Isolierung eintritt.

Eine vorteilhafte Ausführungsform der Erfindung sieht vor, dass bei der Elektrodenstruktur die Elektrodenabschnitte wenigstens zum Teil jeweils als einen Streifenelektrodenabschnitt gebildet sind.

Bevorzugt sieht eine Fortbildung der Erfindung vor, dass bei der Elektrodenstruktur die Elektrode Kammteilelektroden aufweist, bei denen die hieran gebildeten, voneinander getrennten Elektrodenabschnitte wenigstens abschnittsweise ineinandergreifend angeordnet sind.

### Beschreibung bevorzugter Ausführungsbeispiele der Erfindung

Die Erfindung wird im folgenden anhand von bevorzugten Ausführungsbeispielen unter Bezugnahme auf Figuren näher erläutert. Hierbei zeigen:
- Fig. 1: eine schematische Teildarstellung eines lichtemittierenden organischen Bauelementes,
- Fig. 2: eine schematische Darstellung eines Abschnitts des Bauelementes in Fig. 1 im Detail,
- Fig. 3: eine schematische Schnittdarstellung eines Abschnitts einer Elektrodenstruktur einer elektrischen Sicherungsstruktur, bei der eine elektrisch dotierte Schicht aus organischem Material teilweise von einer Metallschicht bedeckt ist,
- Fig. 4: eine schematische Schnittdarstellung eines Abschnitts einer Elektrodenstruktur einer elektrischen Sicherungsstruktur, bei der eine elektrisch dotierte Schicht aus organischem Material vollständig von einer Metallschicht bedeckt ist, Diese Struktur kann sowohl mit einer dotierten organischen Schicht als auch mit einer undotierten und nicht leitfähigen organischen Schicht ausgeführt werden, da hier der Strompfad nicht (zwangsläufig) durch die organische Schicht führt.
- Fig. 5: eine schematische Schnittdarstellung eines Abschnitts einer Elektrodenstruktur einer elektrischen Sicherungsstruktur, bei der eine elektrisch dotierte Schicht aus organischem Material einseitig einschließend von einer Metallschicht bedeckt ist,
- Fig. 6: eine Strom-Spannungs-Kennlinie für eine Sicherungsstruktur gemäß Fig. 4 für verschiedene organische Materialien, nämlich Bphen (Vierecke) und NPD (Drachenviereck),
- Fig. 7: eine Strom-Spannungs-Kennlinie für eine Sicherungsstruktur gemäß Fig. 3,
- Fig. 8: eine schematische Darstellung eines Abschnitts einer optisch transparenten Elektrode aus ITO mit einem hierauf gebildeten Metallgitter und
- Fig. 9: eine schematische Schnittdarstellung der optisch transparenten Elektrode aus Fig. 8.

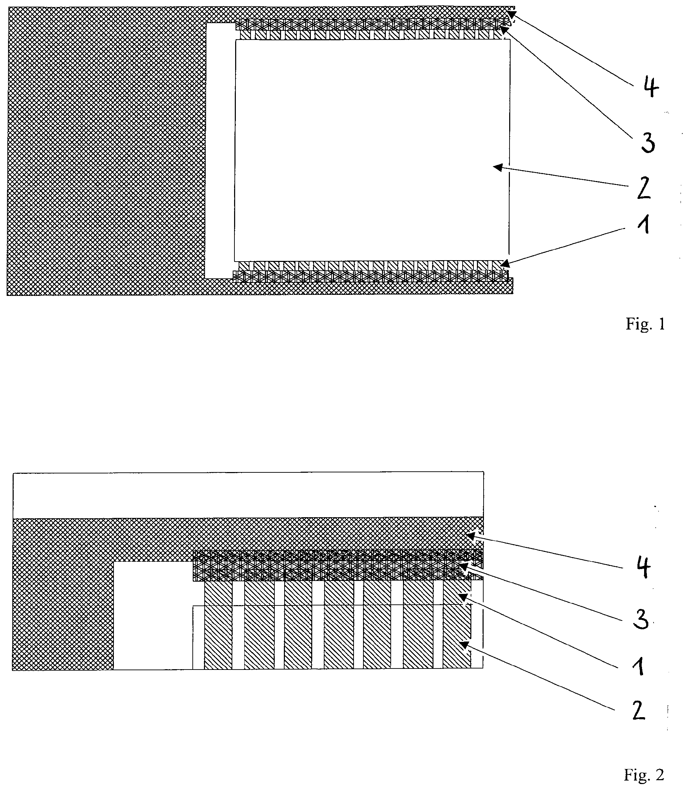

Fig. 1 zeigt eine schematische Teildarstellung eines lichtemittierenden organischen Bauelementes. Streifenförmige Elektrodenabschnitte 1 sind unterhalb eines organischen Bereiches 2 angeordnet und über eine elektrische Sicherungsstruktur 3 an äußere Elektrodenabschnitte 4 elektrisch gekoppelt, die eine Art Zuleitung bilden. Die streifenförmigen Elektrodenabschnitte 1 und die äußeren Elektrodenabschnitte 4 bilden gemeinsam eine Elektrode des Bauelementes, über welche im Zusammenwirken mit einer zugeordneten Gegenelektrode (nicht dargestellt) eine elektrische Betriebsspannung an den organischen Bereich 2 angelegt wird, so dass dort freie Ladungsträger in Form von Löchern und Elektroden erzeugt werden, die dann unter Abgabe von Licht rekombinieren, wie dieses für lichtemittierende organische Bauelemente allgemein bekannt ist.

Der organische Bereich 2 ist über seine flächige Ausdehnung mit einer einheitlichen Materialzusammensetzung gebildet, so dass Licht einheitlicher Farbe abgeben wird. Die konkrete Ausgestaltung des organischen Bereiches 2 kann jedoch je nach Anwendungsfall beliebig gewählt werden. Hierzu stehen die verschiedenen bekannten Bauarten lichtemittierender organischer Bauelemente zur Verfügung. Der organische Bereich 2 wird in üblicher Art und Weise prozessiert, zum Beispiel mittels Vakuumverdampfung, Aufdrucken oder anderer bekannter, schichtbildender Verfahren. Auch eine Kombination dieser Verfahren kann verwendet werden. In diesem Zusammenhang ist es bekannt, Masken zu nutzen, um bestimmte Schichten nur in Teilbereichen des Bauelementes herzustellen. Solche Masken, die auch als Schattenmasken bezeichnet werden, können verwendet werden, um die elektrische Sicherungsstruktur 3, sofern dieses in einer Ausgestaltung organisches Material umfasst, zusammen mit einer Schicht aus dem organischen Bereich 2 herzustellen, so dass die elektrische Sicherungsstruktur 3 zumindest teilweise aus der gleichen Materialzusammensetzung wie die gleichzeitig hergestellte Schicht in dem organischen Bereich 2 ist. Beispielsweise kann es sich bei der organischen Schicht in der Sicherungsstruktur 3 um eine elektrisch dotierte Schicht aus Matrixmaterial und eindotiertem Material handeln. Es sind verschiedene Ausgestaltungen derartiger elektrisch dotierter Schichten als solche dem Fachmann bekannt.

Im Überlappungsbereich zwischen streifenförmigen Elektrodenabschnitten 1 und organischem Bereich 2 ist ein aktiver, lichtemittierender Bereich des Bauelementes gebildet.

Der unter Verwendung von Schattenmasken hergestellte, organische Bereich 2 ist groß genug, um einfache Schattenmasken und Prozesse zu verwenden. Trotzdem sind die streifenförmigen Elektrodenabschnitte 1 demgegenüber klein und in ihren Ausmaßen lediglich durch den Prozess der Prozessierung der Elektrode begrenzt. Deren Prozessierung kann beispielsweise mittels Photolithografie erfolgen, wodurch sehr kleine Abmessungen im Mikrometerbereich herstellbar sind. Nutzbar sind allgemein die für die Elektrodenprozessierung als solche bekannten Verfahren.

Fig. 2 zeigt eine schematische Darstellung eines Abschnitts des Bauelementes in Fig. 1 im Detail.

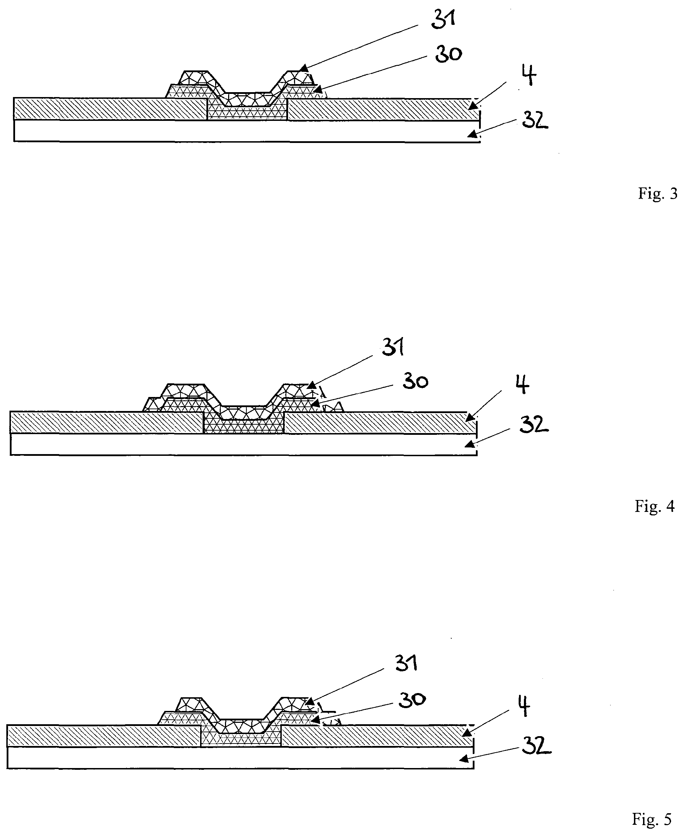

Fig. 3 zeigt eine schematische Schnittdarstellung eines Abschnitts einer Elektrodenstruktur mit einer elektrischen Sicherungsstruktur, bei der eine elektrisch dotierte Schicht 30 aus organischem Material teilweise von einer Metallschicht 31 bedeckt ist. Ein Strompfad verläuft über die Metallschicht und teilweise über die elektrisch dotierte Schicht 30. Weiterhin sind gezeigt ein Substrat 32, auf welchem das oder die Bauelemente aufgebracht sind. In der dargestellten Ausführungsform ist die Metallschicht 31 nicht in Berührungskontakt mit den äußeren Elektrodenabschnitten 4. In einem Ausführungsbeispiel hat die elektrische Sicherungsstruktur nach Fig. 3 den nachfolgend beschriebenen Aufbau. Auf zwei benachbarte parallel verlaufende ITO-Streifen mit einer Dicke von etwa 90 nm und einem Abstand zueinander von etwa 1,27 mm wurde zunächst eine etwa 2,54 mm breite und etwa 100 nm dicke Schicht 2,4,7,9 - Tetraphenyl - 1,10 - phenanthrolin dotiert mit 8 Gewichtsprozent Tetrakis(1,3,4,6,7,8-hexahydro-2H-pyrimido[1,2-a]pyrimidinato)di-Wolfram aufgedampft, welche die beiden ITO-Streifen jeweils auf kompletter Breite bedeckte. Nun wurde in einem zweiten Schritt eine etwa 8 nm dicke Aluminiumschicht mit einer Breite von etwa 2,5 mm über die organische, n-dotierte Schicht gedampft, wobei die Aluminiumschicht mit keinem der beiden ITO-Streifen in direktem Kontakt war. Nun wurde zwischen beiden ITO-Streifen eine Spannung angelegt, und der fließende Strom wurde gemessen. Beim erreichen eines Stromes von etwa 19 mA bricht die elektrische Leitfähigkeit zusammen.

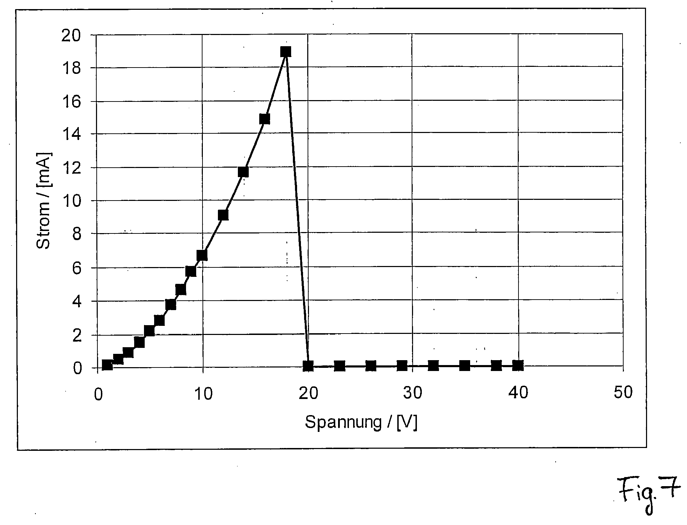

Fig. 7 zeigt eine Strom-Spannungs-Kennlinie für eine Sicherungsstruktur gemäß Fig. 3. Fig. 4 zeigt eine schematische Schnittdarstellung eines Abschnitts einer Elektrodenstruktur mit einer elektrischen Sicherungsstruktur, bei der im Unterschied zu Fig. 3 die elektrisch dotierte Schicht 30 aus organischem Material vollständig von der Metallschicht 31 bedeckt ist. In der dargestellten Ausführungsform ist die elektrisch dotierte Schicht 30 in Berührungskontakt mit den äußeren Elektrodenabschnitten 4. In einer alternativen Ausgestaltung (nicht dargestellt) ist anstelle der elektrisch dotierten Schicht 30 eine elektrisch nicht dotierte Schicht as organischem Material vorgesehen, wobei der Schichtaufbau in gleicher Weise erfolgen kann, wie dies Fig. 4 zeigt. Das organische Material muss in dieser Ausführung nicht elektrisch leitend sein, da ein Strompfad nicht zwangsläufig über das organische Material verläuft.

In einem Ausführungsbeispiel hat die elektrische Sicherungsstruktur nach Fig. 4 den nachfolgend beschriebenen Aufbau. Auf zwei benachbarte parallel verlaufende ITO-Streifen mit einer Dicke von etwa 90 nm und einem Abstand zueinander von etwa 1,27 mm wurde zunächst eine organische Schicht aus etwa 20 nm NPD (N,N'-Di(naphtalen-1-yl)-N,N'-diphenylbenzidin) oder etwa 20 nm BPhen (Bathophenantrolin) abgeschieden. Hierbei bedeckte die organische Schicht die ITO-Streifen nur teilweise, jedoch den Bereich zwischen den Streifen komplett auf einer Breite von etwa 2,54 mm. Nun wurde eine etwa 20 nm dicke Aluminiumschicht mittels einer Schattenmaske so aufgedampft, dass sie die organische Schicht auf einer Breite von etwa 2,5 mm bedeckte und mit beiden ITO-Streifen in direktem elektrischem Kontakt stand. An diese Bauteile wurde nun jeweils zwischen den zwei ITO-Streifen eine Spannung angelegt, und der fließende Strom wurde aufgezeichnet.

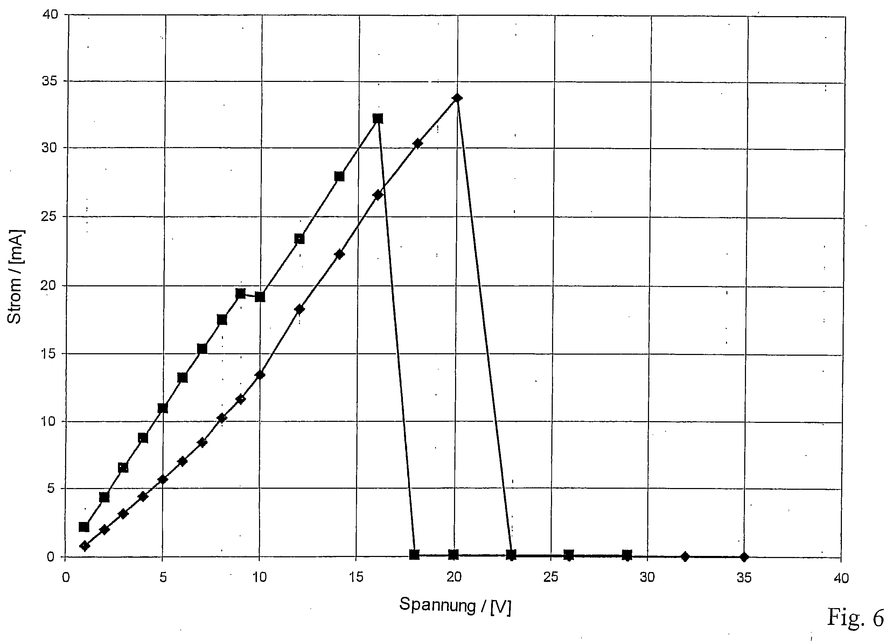

Fig. 6 zeigt eine Strom-Spannungs-Kennlinie für die Elektrodenstruktur mit der Sicherungsstruktur gemäß Fig. 4 für verschiedene organische Materialien, nämlich Bphen (Vierecke) und NPD (Drachenviereck). Für die verschiedenen organischen Materialien wurde die Dicke der Metallschicht konstant gehalten. Für das Material mit der höheren Glastemperatur (NPD) ergibt sich auch eine höhere Spannung / Strom, bei welcher die Sicherungsstruktur zerstört wird. Die Schicht aus organischem Material ist nicht elektrisch dotiert. Es ergibt sich, dass beim Erreichen eines kritischen Stromes (etwa 33 mA im Falle von BPhen und etwa 34 mA im Falle von NPD) der Stromfluss zusammenbricht, da sich die Metallschicht so stark aufheizt, dass die darunter liegende organische Schicht aufgeschmolzen wird, wodurch die Metallbahn zwischen den beiden ITO-Streifen unterbrochen wurde.

Fig. 5 zeigt eine schematische Schnittdarstellung eines Abschnitts einer Elektrodenstruktur mit einer elektrischen Sicherungsstruktur, bei der die elektrisch dotierte Schicht 30 aus organischem Material einseitig einschließend von der Metallschicht 31 bedeckt ist. Ein Strompfad verläuft über die elektrisch dotierte Schicht 30.

Zur Verbesserung einer Schichtleitfähigkeit bei optisch transparenten Elektroden wird in lichtemittierenden organischen Bauelementen der flächigen und optisch transparenten Elektrode häufig ein Metallgitter überlagert. Durch das Metallgitter fließt ein Großteil des Stromes mit geringen ohmschen Verlusten.

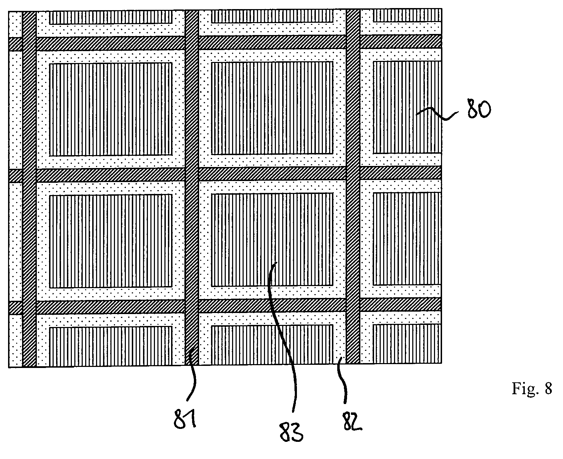

Fig. 8 zeigt eine schematische Darstellung eines Abschnitts einer optisch transparenten Elektrode 80 aus ITO mit einem hierauf gebildeten Metallgitter 81. Entlang des Metallgitters 81 sind beidseitig elektrische Sicherungsstrukturen 82 in einer der vorgenannten Ausführungsformen gebildet. Mit Hilfe des Metallgitters 81 lässt sich insbesondere bei größeren Flächen die Homogenität der Leuchterscheinung des Bauelementes wesentlich verbessern. Mit Hilfe der elektrischen Sicherungsstruktur 82 ist ein solcher Elektrodenaufbau gegen Kurzschlüsse abgesichert. Aufgrund des Metallgitters 81 sind Teilabschnitte 83 der optisch transparenten Elektrode 80 gebildet. Entsteht nun in einem der Teilabschnitte 83 ein Kurzschluss, so wird dieser Teilabschnitt mittels der elektrischen Sicherungsstruktur 82 von den Bahnen des Metallgitters 81 elektrisch isoliert.

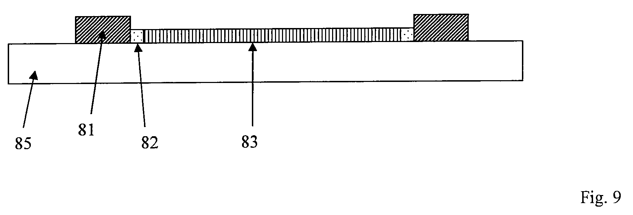

Fig. 9 zeigt eine schematische Schnittdarstellung der optisch transparenten Elektrode 80 aus Fig. 8, wobei auch ein Trägersubstrat 85 dargestellt ist.

Die beschriebenen Ausführungsformen können sowohl zur Ausbildung der Sicherungsstruktur in beliebigen elektronischen Bauelementen genutzt werden, insbesondere einem einzelnen lichtemittierenden organischen Bauelement oder auch zur Ausführung der Bauelementsicherungsstruktur zwischen zusammengeschalteten lichtemittierenden organischen Bauelementen.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Elektrodenstruktur für ein elektronisches Bauelement, mit einer Elektrode aus Elektrodenabschnitten und einem oder mehreren weiteren Elektrodenabschnitten, welche die Elektrodenabschnitte elektrisch miteinander verbinden, wobei eine den Elektrodenabschnitten zugeordnete, elektrische Sicherungsstruktur gebildet ist, die konfiguriert ist, bei Überschreitung eines Grenzstroms eine elektrische Verbindung zu unterbrechen, **dadurch gekennzeichnet, dass** die elektrische Sicherungsstruktur eine Schicht aus organischem Material und eine Metallschicht aufweist.

2. Elektrodenstruktur nach Anspruch 1, **dadurch gekennzeichnet, dass** die elektrische Sicherungsstruktur mit einer Sicherungsteilstruktur, die einer Teilmenge der Elektrodenabschnitte zugeordnet ist, und einer weiteren Sicherungsteilstruktur gebildet ist, die einer weiteren Teilmenge der Elektrodenabschnitte zugeordnet ist.

3. Elektrodenstruktur nach Anspruch 1 oder 2, **dadurch gekennzeichnet, dass** die elektrische Sicherungsstruktur mit wenigstens einer Sicherungseinzelstruktur gebildet ist, die einem einzelnen Elektrodenabschnitt der Elektrodenabschnitte zugeordnet ist.

4. Elektrodenstruktur nach mindestens einem der vorangehenden Ansprüche, **dadurch gekennzeichnet, dass** das organische Material elektrisch p- oder n-dotiert ist.

5. Elektrodenstruktur nach mindestens einem der vorangehenden Ansprüche, **dadurch gekennzeichnet, dass** die Elektrodenabschnitte wenigstens zum Teil jeweils als einen Streifenelektrodenabschnitt gebildet sind.

6. Elektrodenstruktur nach mindestens einem der vorangehenden Ansprüche, **dadurch gekennzeichnet, dass** die Elektrode Kammteilelektroden aufweist, an denen die Elektrodenabschnitte gebildet sind, wobei die Elektrodenabschnitte wenigstens abschnittsweise ineinandergreifend angeordnet sind.

7. Elektrodenstruktur nach mindestens einem der vorangehenden Ansprüche, **dadurch gekennzeichnet, dass** die elektrische Sicherungsstruktur als eine Schmelzsicherungsstruktur ausgeführt ist, sodass sie bei Überschreitung eines Grenzstroms schmilzt.

8. Lichtemittierendes organisches Bauelement, mit:
- einer Elektrode,
- einer Gegenelektrode und
- einem zwischen der Elektrode und der Gegenelektrode angeordneten organischen Bereich,
wobei die Elektrode Elektrodenabschnitte aufweist, die jeweils wenigstens teilweise überlappend und in Kontakt mit dem organischen Bereich ausgeführt sind und die mit Hilfe eines oder mehrerer weiterer Elektrodenabschnitte die Elektrode bildend elektrisch miteinander verbunden sind, und wobei die Elektrode mit einer Elektrodenstruktur nach mindestens einem der vorangehenden Ansprüche gebildet ist.

9. Verfahren zum Herstellen eines lichtemittierenden organischen Bauelementes, bei dem eine Elektrode und eine Gegenelektrode sowie ein zwischen der Elektrode und der Gegenelektrode angeordneter organischer Bereich gebildet werden, wobei die Elektrode mit Elektrodenabschnitten hergestellt wird, die jeweils wenigstens teilweise überlappend und in Kontakt mit dem organischen Bereich gebildet werden und die mit Hilfe eines oder mehrerer weiterer Elektrodenabschnitte zu der Elektrode elektrisch miteinander verbunden werden, und wobei die Elektrode mit einer Elektrodenstruktur nach mindestens einem der Ansprüche 1 bis 7 gebildet wird.

10. Anordnung mit mehreren lichtemittierenden organischen Bauelementen, die jeweils mit einer zugeordneten Elektrode und einer zugeordneten Gegenelektrode und einem zwischen der zugeordneten Elektrode und der zugeordneten Gegenelektrode angeordneten organischen Bereich gebildet sind, wobei die zugeordneten Elektroden der mehreren lichtemittierenden organischen Bauelemente in einer Schaltung elektrisch miteinander verbunden sind und eine der Schaltung zugeordnete Bauelementsicherungsstruktur eine Elektrodenstruktur nach mindestens einem der Ansprüche 1 bis 7 aufweist.

11. Anordnung nach Anspruch 10, **dadurch gekennzeichnet, dass** die mehreren lichtemittierenden organischen Bauelementen auf einem gemeinsamen Substrat gebildet sind.

## Claims

1. An electrode structure for an electronic component with an electrode made from electrode sections and one or more further electrode sections which electrically connect the electrode sections with each other, wherein an electrical safety structure allocated to the electrode sections is formed, wherein the electrical safety structure is configured to interrupt an electrical connection if a limit current is exceeded, **characterized in that** the electrical safety structure comprises a layer made of an organic material and a metal layer.

2. The electrode structure according to claim 1, **characterized in that** the electrical safety structure is formed with a safety substructure which is allocated to a subset of the electrode sections, and a further safety substructure which is allocated to a further subset of the electrode sections.

3. The electrode structure according to claim 1 or 2, **characterized in that** the electrical safety structure is formed with at least one individual safety structure which is allocated to an individual electrode section of the electrode sections.

4. The electrode structure according to at least one of the preceding claims, **characterized in that** the organic material is electrically p- or n-doped.

5. The electrode structure according to at least one of the preceding claims, **characterized in that** the electrode sections are each formed at least partially as a strip electrode section.

6. The electrode structure according to at least one of the preceding claims, **characterized in that** the electrode has comb-shaped sub-electrodes at which the electrode sections are formed, the electrode sections being arranged intermeshing at least in areas.

7. The electrode structure according to at least one of the preceding claims, **characterized in that** the electrical safety structure is implemented as a safety fuse structure such that it melts if a limit current is exceeded.

8. A light-emitting organic component, comprising:
- an electrode,
- a counter electrode, and
- an organic region arranged between the electrode and the counter electrode,
wherein the electrode comprises electrode sections, each of which are implemented at least partially overlapping and in contact with the organic region and which are electrically connected with each other by means of one or more further electrode sections, forming the electrode, and wherein the electrode has an electrical safety structure according to at least one of the preceding claims.

9. A method for the production of a light-emitting organic component in which an electrode and a counter electrode and an organic region located between the electrode and the counter electrode are formed, wherein the electrode is produced with electrode sections, each of which are formed at least partially overlapping and in contact with the organic region and which are electrically connected with each other to the electrode by means of one or more further electrode sections, and wherein the electrode is implemented with an electrical safety structure according to at least one of the claims 1 to 7.

10. An array comprising several light-emitting organic components, each of which are formed with an allocated electrode and an allocated counter electrode and an organic region located between the allocated electrode and the allocated counter electrode, wherein the allocated electrodes of the several light-emitting organic components are electrically connected with each other in a connection, and a component safety structure according to at least one of the claims 1 to 7 which is allocated to the connection.

11. The array according to claim 10, **characterized in that** the several light-emitting organic components are formed on a common substrate.

## Revendications

1. Structure d'électrode pour un composant électronique avec une électrode composée de sections d'électrode et une ou plusieurs autres sections d'électrode, lesquelles relient entre elles électriquement les sections d'électrode, une structure de protection électrique attribuée aux sections d'électrode étant formée qui est configurée pour interrompre une liaison électrique en cas de dépassement d'un courant limite, **caractérisée en ce que** la structure de protection électrique comporte une couche composée d'un matériau organique et d'une couche métallique.

2. Structure d'électrode selon la revendication 1, **caractérisée en ce que** la structure de protection électrique est formée avec une partie de structure de protection qui est attribuée à une quantité partielle des sections d'électrode et une autre partie de structure de protection qui est attribuée à une autre quantité partielle des sections d'électrode.

3. Structure d'électrode selon la revendication 1 ou 2, **caractérisée en ce que** la structure de protection électrique est formée avec au moins une structure individuelle de fusible qui est attribuée à une section d'électrode individuelle des sections d'électrode.

4. Structure d'électrode selon au moins l'une quelconque des revendications précédentes, **caractérisée en ce que** le matériau organique est électriquement doté p ou n.

5. Structure d'électrode selon au moins l'une quelconque des revendications précédentes, **caractérisée en ce que** les sections d'électrode sont formées au moins en partie respectivement comme une section d'électrode en bande.

6. Structure d'électrode selon au moins l'une quelconque des revendications précédentes, **caractérisée en ce que** l'électrode comporte des parties d'électrodes à dents sur lesquelles sont formées les sections d'électrode, les sections d'électrode étant au moins disposées s'engrenant l'une dans l'autre par section.

7. Structure d'électrode selon au moins l'une quelconque des revendications précédentes, **caractérisée en ce que** la structure de protection électrique est exécutée comme une structure de fusible coupe-circuit de sorte qu'il fond en cas de dépassement d'un courant limite.

8. Composant organique émetteur de lumière, avec
- une électrode,
- une contre-électrode et
- une zone organique disposée entre l'électrode et la contre-électrode,
l'électrode comportant des sections d'électrode qui sont exécutées se superposant respectivement au moins en partie et en contact avec la zone organique et qui sont reliées électriquement entre elles formant l'électrode à l'aide d'une ou plusieurs autres sections d'électrode et l'électrode étant formée avec une structure d'électrode selon au moins l'une quelconque des revendications précédentes.

9. Méthode servant à fabriquer un composant organique émetteur de lumière pour lequel une électrode et une contre-électrode ainsi qu'une zone organique disposée entre l'électrode et la contre-électrode sont formées, l'électrode étant réalisée avec des sections d'électrode qui sont respectivement formées se superposant et en contact avec la zone organique et qui sont reliées électriquement entre elles formant l'électrode à l'aide d'une ou plusieurs autres sections d'électrode à l'électrode et l'électrode étant formée avec une structure d'électrode selon au moins l'une quelconque des revendications 1 à 7.

10. Agencement avec plusieurs composants organiques émetteurs de lumière, qui sont formés respectivement avec une électrode attribuée et une contre-électrode attribuée et une zone organique disposée entre l'électrode attribuée et la contre-électrode attribuée, les électrodes attribuées des divers composants organiques émetteurs de lumière étant reliés électriquement entre eux dans un circuit et une structure de protection de composant attribuée au circuit comportant une structure d'électrode selon au moins l'une quelconque des revendications 1 à 7.

11. Agencement selon la revendication 10, **caractérisé en ce que** les divers composants organiques émetteurs de lumière sont formés sur un substrat commun.
